# EUROPEAN PATENT APPLICATION

(11) **EP 4 446 297 A1**
(43) Date of publication of application: **16.10.2024**
(21) Application number: 22944596.0
(22) Date of filing: 01.11.2022
(51) Int. Cl.: C04B 35/10, C04B 35/50, C09K 11/00, C04B 35/117, H01L 33/50

(54) **MULTIPHASE FLUORESCENT CERAMIC, PREPARATION METHOD FOR MULTIPHASE FLUORESCENT CERAMIC, AND LIGHT-EMITTING DEVICE**

(30) Priority: 01.06.2022 CN 202210622686
(71) Applicant: YLX Incorporated, Shenzhen, Guangdong 518000 (CN)
(72) Inventor: LI, Qian, Shenzhen, Guangdong 518000 (CN); JIAN, Shuai, Shenzhen, Guangdong 518000 (CN); WANG, Yangang, Shenzhen, Guangdong 518000 (CN)
(74) Representative: Daub, Thomas
(86) International application number: PCT/CN2022/128875
(87) International publication number: WO 2023/231293

(57) **Abstract**

The disclosure discloses a composite fluorescent ceramic, a preparation method of the composite fluorescent ceramic and a light emitting device related to the technical field of optical components. The device includes a luminescent phase, a matrix phase and pores, the luminescent phase includes multiple luminescent crystal grains bonded together, the matrix phase includes multiple matrix crystal grains bonded together, the matrix phase and the luminescent phase are interspersed with each other and distributed in a composite fluorescent ceramic, at least part of pores are distributed in the luminescent phase, at least part of pores are distributed in the matrix phase, and at least part of pores are distributed between the luminescent phase and a Al₂O₃ matrix phase. The composite fluorescent ceramic may have high scattering performance.

## Description

### TECHNICAL FIELD

The present disclosure relates to the technical field of optical components, and in particular, to a composite fluorescent ceramic, a preparation method of the composite fluorescent ceramic and a light-emitting device.

### BACKGROUND

The laser fluorescent light source may realize the advantages of long service life, high efficiency, no pollution and the like. Compared with an LED light source, the laser fluorescent light source has high brightness and the like, and compared with a pure laser light source, the laser fluorescent light source has no speckle problem and requires low cost. Due to the advantages, the laser fluorescent light source has been widely used in the fields of projection display and illumination.

As a core component of the laser fluorescent light source technology, the fluorescent material has performances directly affecting the performance of projection display and illumination products. The fluorescent materials in the prior art often use fluorescent ceramics, but the scattering performance of the existing fluorescent ceramics still needs to be improved. Therefore, a fluorescent material with good scattering performance is urgently required.

### SUMMARY

In view of this, in order to solve the above technical problems, the present disclosure provides a composite fluorescent ceramic, a preparation method of the composite fluorescent ceramic, and a light-emitting device.

In order to achieve the above object, the present disclosure provides a composite fluorescent ceramic, the composite fluorescent ceramic comprises a luminescent phase, a matrix phase and pores.

The luminescent phase includes multiple luminescent crystal grains bonded together.

The matrix phase includes multiple matrix crystal grain bonded together, and the matrix phase and the luminescent phase are interspersed with each other and distributed in the composite fluorescent ceramic.

At least part of the pores is distributed in the luminescent phase, at least part of the pores is distributed in the matrix phase, and at least part of the pores is distributed between the luminescent phase and the matrix phase.

In order to solve the above technical problem, another technical solution adopted by the present disclosure is to provide a preparation method of a composite fluorescent ceramic for preparing the above-mentioned composite fluorescent ceramic.

The preparation method includes:
mixing ceramic raw materials to form mixed powder, the ceramic raw materials including matrix phase raw material powder, luminescent phase raw material powder and pore-forming agent,
forming the mixed powder into a green body,
heat-treating the green body to remove the pore-forming agent, and
sintering the green body after heat-treatment to form the composite fluorescent ceramic.

In order to solve the above technical problem, another technical solution adopted by the present disclosure is to provide a light emitting device. The light emitting device includes an excitation light source and the above composite fluorescent ceramic.

Beneficial Effects: compared with a composite fluorescent ceramic in the related art, for example, the composite fluorescent ceramic prepared by mixing commercially available fluorescent powder particles, ceramic particles and a pore-forming agent for sintering, and the pores thereof being distributed only between the fluorescent powder particles and the ceramic particles and between the ceramic particles themselves, at least part of pores in the composite fluorescent ceramic of the present application are distributed in the luminescent phase, at least part of pores are distributed in the matrix phase, and at least part of pores are distributed between the luminescent phase and the matrix phase. As a result, the scattering performance of the composite fluorescent ceramic may be improved through the pores distributed in the luminescent phase.

### BRIEF DESCRIPTION OF DRAWINGS

FIG. 1 is a schematic structural diagram of a composite fluorescent ceramic according to the present disclosure.
FIG. 2 is a schematic flowchart of a method for preparing a composite fluorescent ceramic according to Embodiment 1 of the present disclosure.
FIG. 3 is a schematic structural diagram of a light emitting device according to the present disclosure.

### DESCRIPTION OF EMBODIMENTS

To enable those skilled in the art to better understand the technical solution of the present disclosure, the present disclosure is further described in detail below with reference to the accompanying drawings and specific embodiments. Obviously, the described embodiments are only a part of the embodiments of the present disclosure, but not all the embodiments. All other implementations, based on the implementations in the present disclosure, obtained by those skilled in the art without creative efforts shall fall within the protection scope of the present disclosure.

At present, a composite fluorescent ceramic is generally prepared by mixing commercially available fluorescent powder particles, ceramic particles and a pore-forming agent for sintering in a preparation process, a luminescent phase in the prepared composite fluorescent ceramic is the fluorescent powder particle, and the fluorescent powder particle is a nearly-spherical single crystal particle, which consists of a single luminescent crystal grain, i.e., a fluorescent crystal grain, so that pores in the prepared composite fluorescent ceramic are distributed only between the fluorescent powder particle and the ceramic particle and between the ceramic particles themselves. That is, the pores are not able to be distributed among the luminescent crystal grains in the luminescent phase.

In order to improve the above technical problems, when preparing a composite fluorescent ceramic, the luminescent phase in the composite fluorescent ceramic does not adopt ceramic particles of a single crystal prepared in advance, but adopts an in-situ synthesis method, so that chemical reactions occur between ceramic raw materials to generate the luminescent phase during the process of preparing the composite fluorescent ceramic. In this case, pores may be formed between luminescent crystal grains in the luminescent phase. Accordingly, the following embodiments are proposed as follows.

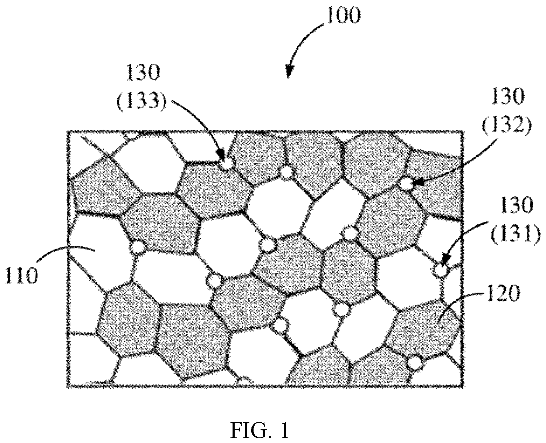

Referring to FIG. 1, FIG. 1 is a schematic structural diagram of a composite fluorescent ceramic according to the present disclosure.

As shown in FIG. 1, the composite fluorescent ceramic 100 includes a luminescent phase (not labeled), a matrix phase (not labeled), and pores 130. The luminescent phase includes multiple luminescent crystal grains 120 bonded together. The matrix phase includes multiple matrix crystal grains 110 bonded together, and the matrix phase and the luminescent phase are interspersed with each other and distributed in the composite fluorescent ceramic. At least part of the pores 130 are distributed in the luminescent phase, at least part of the pores 130 are distributed in the matrix phase, and at least part of the pores 130 are distributed between the luminescent phase and the matrix phase.

As shown in FIG. 1, the pores 130 may be distributed between the luminescent crystal grains 120 in the luminescent phase.

As shown in FIG. 1, since the luminescent phase (shown by the gray region in FIG. 1) and the matrix phase (shown by the white region in FIG. 1) are obtained through a solid phase reaction, the luminescent phase and the matrix phase are not definitely shaped, similar to an amorphous state. The interspersed distribution may refer to that boundaries of the luminescent phase and boundaries of the matrix phase are interspersed with each other. As shown in FIG. 1, one of the boundary of the luminescent phase and the boundary of the matrix phase encloses a caulking groove region, the other one of the boundary of the luminescent phase and the boundary of the matrix phase encloses an embedding region, the embedding region is located in the caulking groove region, and the boundary of the embedding region and the boundary of the caulking groove region are bonded to each other.

Compared with a composite fluorescent ceramic in the related art, for example, the composite fluorescent ceramic is prepared by mixing commercially available fluorescent powder particles, ceramic particles and a pore-forming agent for sintering, pores of the composite fluorescent ceramic are only distributed between the fluorescent powder particles and the ceramic particles and between the ceramic particles, at least part of pores 130 in the composite fluorescent ceramic of the present disclosure are distributed in the luminescent phase, at least part of pores 130 are distributed in the matrix phase, and at least part of pores 130 are distributed between the luminescent phase and the matrix phase, and the scattering performance of the composite fluorescent ceramic may be improved through the pores distributed in the luminescent phase.

Compared with existing composite fluorescent ceramics, the composite fluorescent ceramic 100 of the present disclosure has good scattering performance, so that the diffusion distance of the fluorescent light spot can be reduced, the light spot diffusion is inhibited, the front light extraction efficiency is improved, and the high light extraction efficiency is achieved.

In an embodiment, as shown in FIG. 1, the pores 130 may be uniformly distributed in the composite fluorescent ceramic. The air holes 130 distributed in the luminescent phase are denoted as first air holes 132. The first air holes 132 may be located between multiple luminescent crystal grains 120, for example, located between adjacent and mutually bonded luminescent crystal grains 120 among the multiple luminescent crystal grains 120. The air holes 130 distributed in the matrix phase are denoted as second air holes 131. The second air holes 131 may be located between multiple matrix crystal grains 110, for example, located between adjacent and mutually bonded matrix crystal grains 110 among the multiple matrix crystal grains 110. The air holes 130 distributed between the luminescent phase and the matrix phase are denoted as third air holes 133. The third air holes 133 may be located between adjacent and mutually bonded luminescent crystal grains 120 and matrix crystal grains 110. Each of the luminescent crystal grains 120 and the matrix crystal grains 130 may be considered as a single crystal particle. In addition, some of the pores 130 may be distributed inside the luminescent crystal grains 120 or inside the matrix crystal grains 130.

In an embodiment, as shown in FIG. 1, the volume ratio of the total volume of the pores 130 in the composite fluorescent ceramic 100 is less than 5% and greater than 0.1% (e.g., 4%, 3%, 1%, 0.5%). When the content of the pores 130 is too low, the scattering effect on light is weak, but when the content is too high, the overall thermal conductivity of the composite fluorescent ceramic 100, may be impacted. By keeping the content of the pores 130 in the above range, good scattering may be achieved on the premise of ensuring that the composite fluorescent ceramic 100 has high thermal conductivity.

In an embodiment, the volume ratio of the total volume of the luminescent phase in the composite fluorescent ceramic 100 is within a range from 10% to 90% (e.g., 10%, 30%, 50%, 60%, 68%, 70%, 80%, 90%). According to different volume ratios of the total volume of the luminescent phase in the composite fluorescent ceramic 100, the luminescent phase may present different distributions in the composite fluorescent ceramic 100.

In an embodiment (not shown), the luminescent phases are dispersed granular distributed in the composite fluorescent ceramic, and the matrix phases are distributed between the dispersed luminescent phase. In another embodiment (not shown), the luminescent phase is continuously distributed in meshes in the composite fluorescent ceramic, and the matrix phase is distributed in meshes enclosed by the luminescent phase continuously distributed in meshes. In another embodiment (not shown), the luminescent phase exhibits a mixed state of dispersed granular distribution and continuous distribution in meshes in the composite fluorescent ceramic, that is, the luminescent phase in some regions exhibits dispersed granular distribution, and the luminescent phase in some regions exhibits continuous distribution in meshes. Of course, in some other embodiments, the luminescent phase and the matrix phase may exhibit other forms of distribution.

In an embodiment, as shown in FIG. 1, the particle size of the luminescent crystal grains 120 in the composite fluorescent ceramic 100 is within a range from 1 µm to 10 µm (for example, 1 µm, 2 µm, 3 µm, 5 µm, 7 µm, 8 µm, 9 µm, 10 µm). In an embodiment, the particle size of luminescent crystal grains 120 accounting for 60% to 95% (e.g., 60%, 70%, 80%, 85%, 90% and 95%) of the total number of composite fluorescent ceramic 100 is within a range from 1 µm to 10 µm (e.g., 1 µm, 2 µm, 3 µm, 5 µm, 7 µm, 8 µm, 9 µm, 10 µm). In some embodiments, the particle size of the luminescent crystal grains 120 accounting for 60% to 95% or more in the composite fluorescent ceramic 100 is within a range from 2 µm to 5 µm (e.g., 2 µm, 3 µm, 5 µm). In the present disclosure, the size of the luminescent crystal grains 120 is smaller than the size of the fluorescent powder used in the existing composite fluorescent ceramics, thereby increasing the number of the luminescent crystal grains 120 as the luminescent center, improving the dispersibility, and facilitating the uniformity of the luminescent color and the limitation on light spot diffusion.

In the present disclosure, the type of the luminescent phase is not particularly limited, and an appropriate luminescent phase may be selected according to actual needs. In an embodiment, the luminescent phase is a garnet luminescent phase (e.g., YAG luminescent phase, LuAG luminescent phase). The luminescent crystal grains 120 may be doped with rare earth elements, such as one or more of lanthanides, such as one or more of cerium (Ce) and europium (Eu).

In the present disclosure, the type of the matrix phase is not particularly limited. An appropriate matrix phase may be selected according to actual needs. In an embodiment, the matrix phase is one or more of an aluminum oxide matrix phase, an aluminum nitride matrix phase, a magnesium oxide matrix phase, a zinc oxide matrix phase, a yttrium oxide matrix phase, a magnesium aluminate spinel matrix phase, and a yttrium aluminum garnet matrix equivalent matrix phase.

In an embodiment, the particle size of the matrix crystal grains 110 in the composite fluorescent ceramic 100 is within a range from 1 µm to 10 µm (e.g., 1 µm, 2 µm, 3 µm, 5 µm, 7 µm, 8 µm, 9 µm, 10 µm). In an embodiment, the particle size of matrix crystal grains 110, which accounts for 60% to 95% (e.g., 60%, 70%, 80%, 85%, 90%, 95%) of the total number of composite fluorescent ceramic 100 is within a range from 1 µm to 10 µm (e.g., 2 µm, 3 µm, 5 µm, 7 µm, 8 µm, 9 µm, 10 µm). In an embodiment, the particle size of matrix crystal grains 110, which accounts for 60% to 95% of the total number of composite fluorescent ceramic 100 is within a range from 2 µm to 5 µm (e.g., 2 µm, 3 µm, 5 µm). The size of the matrix crystal grains 110 in the present disclosure is smaller than the size of the matrix crystal grains used in the existing composite fluorescent ceramic, so that the quantity of the matrix crystal grains 110 in the present application is larger, that is, the number of scattering centers is larger, thereby facilitating increasing the scattering performance and improving the uniformity of the luminous color and the limitation on the light spot diffusion.

Hereinafter, the present disclosure provides a method for preparing a composite fluorescent ceramic 100 according to any one of the above embodiments.

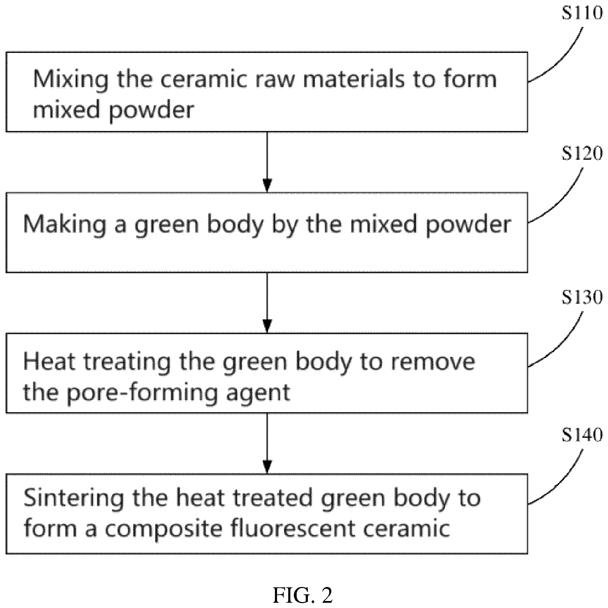

Referring to FIG. 2, FIG. 2 is a schematic flowchart of a method for preparing a composite fluorescent ceramic according to Embodiment 1 of the present disclosure.

As shown in FIG. 2, the preparation method of the composite fluorescent ceramic of the present disclosure may include the following steps S110 to S140.

Step S110: mixing the ceramic raw materials to form mixed powder.

The ceramic raw material includes matrix phase raw material powder, luminescent phase raw material powder and a pore-forming agent. The matrix phase raw material powder and the luminescent phase raw material powder may be selected according to the aforementioned types of the matrix phase and the luminescent phase, which is not particularly limited. In step S110, all the matrix phase raw material powder, the luminescent phase raw material powder and the pore-forming agent may be directly mixed by a suitable mixing means (such as ball milling) to form a mixed powder.

In another embodiment, the luminescent phase is a lanthanide-doped garnet luminescent phase and the matrix phase is an aluminum oxide matrix phase. On the basis, the matrix phase raw material powder includes first aluminum oxide powder, and the luminescent phase raw material powder includes second aluminum oxide powder, yttrium oxide powder and lanthanide oxide powder.

In another embodiment, the mass ratio of the sum of the first aluminum oxide powder and the second aluminum oxide powder to the yttrium oxide powder is within a range from 1: 1 to 6: 1 (for example, 1: 1, 1.5: 1, 5: 3, 2: 1, 2.5: 1, 6: 1). In some embodiments, a mass ratio of the sum of the first aluminum oxide powder and the second aluminum oxide powder to the yttrium oxide powder is within a range from 1.5: 1 to 3: 1 (for example, 1.5: 1, 5: 3, 2.5: 1, 3: 1).

In another embodiment, the mass of the lanthanide oxide powder is within a range from 0.1% to 2% (e.g., 0.1%, 0.3%, 0.4%, 2%) of the mass of the yttrium oxide powder. In an embodiments, the mass of the lanthanide oxide powder is within a range from 0.3% to 1% (e.g., 0.3%, 0.4%, 1%) of the mass of the yttrium oxide powder.

In another embodiment, the mass of the pore-forming agent is within a range from 4% to 20% (e.g., 4%, 8%, 10%, 20%) of the mass of the sum of the matrix phase raw material powder and the luminescent phase raw material powder.

In addition, the type of the pore-forming agent is not particularly limited. For example, the pore-forming agent may be one or more of polymethyl methacrylate (PMMA) microspheres, polystyrene (polystyrene, PS) microspheres or starch.

Step S120: forming the mixed powder into a green body.

In an exemplary embodiment of step S120, the mixed powder may be placed in a mold, and the mixed powder is dry-pressed to bond the mixed powder together to form a shape corresponding to the mold. It may be understood that the shape of the green body depends on the shape and size of the mold, and may be adjusted according to requirements, which is not limited herein. Of course, other forming methods may also be adopted as required, such as semi-dry pressing forming, plastic forming, grouting forming or static pressure forming. In addition, during the forming process, an appropriate auxiliary agent may be added into the mixed powder to assist in forming.

Step S130: heat-treating the green body to remove the pore-forming agent.

The green body may be heat-treated in step S130 to decompose the pore-forming agent in the green body. In another embodiment, for example, the green body is heat-treated at a pore-forming agent decomposition temperature of 400 °C to 1000 °C (e.g., 400 °C, 500 °C, 654 °C, 700 °C, 837 °C, 1000 °C) for 0.5 h to 6 h (e.g., 0.5 h, 1 h, 2.4 h, 3 h, 5 h, 6 h) to decompose the pore-forming agent. It may be understood that in the process of heat-treatment at the pore-forming agent decomposition temperature, the pore-forming agent is volatilized in a high-temperature environment, and pores are formed at corresponding positions in the green body after the pore-forming agent is decomposed. In addition, the degumming treatment may be performed simultaneously during the heat-treatment.

In an exemplary embodiment of step S130, the green body may be placed in a muffle furnace for heat-treatment, other suitable heat-treatment equipment may be used.

Step S140: sintering the heat-treated green body to form a composite fluorescent ceramic.

In step S140, the heat-treated green body may be sintered to form a composite fluorescent ceramic, the composite fluorescent ceramic includes a luminescent phase, a matrix phase and pores. The luminescent phase includes multiple luminescent crystal grains bonded together. The matrix phase includes multiple matrix crystal grain bonded together. The matrix phase and the luminescent phase are interspersed with each other and distributed in the composite fluorescent ceramic. At least part of the pores is respectively distributed in the luminescent phase, at least part of the pores is distributed in the matrix phase, and at least part of the pores is distributed between the luminescent phase and the matrix phase.

In an embodiments, during the sintering process in step 140, the luminescent phase raw material powder in the green body generates a luminescent phase. The luminescent phase includes multiple luminescent crystal grains bonded together. The matrix phase raw material powder in the green body forms a matrix phase. The matrix phase includes multiple luminescent crystal grains bonded together. The pores in the green body are reduced.

The equipment for sintering is not particularly limited. For example, the equipment for sintering may be a vacuum sintering furnace, a hot pressing sintering furnace, or a Spark Plasma Sintering (SPS) sintering furnace.

In another embodiment, the heat-treated green body may be sintered at a sintering temperature of 1400 °C to 1700 °C (e.g., 1400 °C, 1450 °C, 1500 °C, 1548 °C, 1630 °C, 1700 °C) for 0.1 h to 6 h (e.g., 0.1 h, 0.5 h, 1 h, 2 h, 3.4 h, 4.6 h, 5 h, 6 h) to form a composite fluorescent ceramic sintered element. Further, the composite fluorescent ceramic sintered element may be annealed in an air atmosphere to form a composite fluorescent ceramic.

Optionally, based on the preparation method of the composite fluorescent ceramic according to Embodiment 1, the preparation method of the composite fluorescent ceramic according to Embodiment 2 is provided.

Prior to step S140, the method includes: increasing the pore-forming agent decomposition temperature to a pre-sintering temperature of 1000 °C to 1600 °C (for example, 1000 °C, 1150 °C, 1200 °C, 1300 °C, 1360 °C, 1430 °C, 1540 °C, 1600 °C), and pre-sintering the green body at the pre-sintering temperature for 0.5 h to 4 h (for example, 0.5 h, 0.7 h, 1 h, 1.6 h, 2.5 h, 3 h, 3.6 h, 4.3 h, 5 h, 6 h) to form ceramic intermediate.

Further, based on the above embodiments, step S140 includes: sintering a ceramic intermediate at a sintering temperature of 1400 °C to 1700 °C for 0.1 h to 6 h to form a composite fluorescent ceramic sintered element, and annealing the composite fluorescent ceramic sintered element in an air atmosphere to form the composite fluorescent ceramic.

Further, in another embodiment, prior to sintering the ceramic intermediate, the method includes: processing a shape and a size of the ceramic intermediate. The shape and size of the ceramic intermediate may be processed according to the required product shape.

On the basis of the aforementioned the preparation method of the composite fluorescent ceramic according to Embodiment 1 or Embodiment 2, the preparation method of the composite fluorescent ceramic according to Embodiment 3 is provided.

Step S 110 includes: mixing luminescent phase raw material powder to prepare prefabricated powder, sintering the prefabricated powder at a precursor sintering temperature of 1000 °C to 1600 °C (for example, 1000 °C, 1150 °C, 1200 °C, 1300 °C, 1360 °C, 1430 °C, 1540 °C and 1600 °C) for 0.5 h to 4 h (for example, 0.5 h, 0.7 h, 1 h, 1.6 h, 2.5 h, 3 h, 3.6 h, 4.3 h, 5 h and 6 h) to form a luminescent phase precursor, and mixing the luminescent phase precursor, the matrix phase raw material powder and the pore-forming agent to form mixed powder.

In another embodiment, the luminescent phase raw material powder and a suitable auxiliary agent, for example, the second aluminum oxide powder, the yttrium oxide powder, the lanthanide oxide powder, and the binder, may be mixed via first ball milling to form a mixed slurry. The mixed slurry is then processed with spray granulation to form a prefabricated powder. In an embodiment, the binder may be 0.5% to 5% of the total weight of the ceramic raw material. In addition, the sintered luminescent phase precursor may be processed via ball milling, drying, sieving and the like. The luminescent phase precursor, the matrix phase raw material powder and the pore-forming agent may be mixed via second ball milling to form a mixed powder, and the mixed powder may be further processed by drying, sieving and the like.

On the basis of the preparation method of the composite fluorescent ceramic according to Embodiment 1 or the Embodiment 2, the preparation method of the composite fluorescent ceramic according to Embodiment 4 is provided. The pore-forming agent in Embodiment 4 includes a first pore-forming agent and a second pore-forming agent.

Step S110 includes: mixing luminescent phase raw material powder and the first pore-forming agent to prepare prefabricated powder, sintering the prefabricated powder at a precursor sintering temperature of 1000 °C to 1600 °C (for example, 1000 °C, 1150 °C, 1200 °C, 1300 °C, 1360 °C, 1430 °C, 1540 °C and 1600 °C) for 0.5 h to 4 h (for example, 0.5 h, 0.7 h, 1 h, 1.6 h, 2.5 h, 3 h, 3.6 h, 4.3 h, 5 h and 6 h) to form a luminescent phase precursor, and mixing the luminescent phase precursor, the matrix phase raw material powder and the second pore-forming agent to form mixed powder.

In another embodiment, the luminescent phase raw material powder, the first pore-forming agent, and a suitable auxiliary agent, for example, the second aluminum oxide powder, the yttrium oxide powder, the lanthanide oxide powder, the first pore-forming agent, and the binder, may be mixed via the first ball milling to form a mixed slurry. The mixed slurry is then processed with spray granulation to form a prefabricated powder. In one embodiment, the binder may be 0.5% to 5% of the total weight of the ceramic raw material. In addition, the sintered luminescent phase precursor may be processed with ball milling, drying, sieving and the like. The mixing of the luminescent phase precursor, the matrix phase raw material powder and the second pore-forming agent may be mixed via the second ball milling to form a mixed powder. The mixed powder may be further processed by drying and sieving.

In an embodiment, a mass ratio of the first pore-forming agent to the second pore-forming agent may be within a range of 0.1 to 10 (e.g., 0.1, 1, 2, 3, 6, 10).

The preparation method of the composite fluorescent ceramic of the present disclosure may be described below through specific embodiments.

### Embodiment 1

In Embodiment 1, a YAG: Ce luminescent phase was obtained through solid phase reaction, and pores were formed by PMMA microspheres, and a composite fluorescent ceramic with a porous structure was obtained. The preparation process thereof is as below.

The ceramic raw materials were ball-milling mixed.

The ceramic raw material includes matrix phase raw material powder, luminescent phase raw material powder and PMMA microspheres, the matrix phase raw material powder includes first nano aluminum oxide powder, and the luminescent phase raw material powder includes second nano aluminum oxide powder, nano yttrium oxide powder and nano cerium oxide powder.

The mass ratio of the first nano aluminum oxide powder to the second nano aluminum oxide powder to the nano yttrium oxide powder is 2.5: 1, the mass of the nano cerium oxide powder is 0.3% of the mass of the nano yttrium oxide powder, and the mass of the PMMA microspheres is 8% of the sum of the mass of the matrix phase raw material powder and the luminescent phase raw material powder.

The second nano aluminum oxide powder, the nano yttrium oxide powder and the nano cerium oxide powder were respectively weighed according to a stoichiometric ratio.

Preparation of green body includes: placing the mixed powder into a mold, and dry pressing the mixed powder, to form a green body.

The green body was placed in a muffle furnace, heated to a pore-forming agent decomposition temperature of 700 °C from room temperature, and heat-treated for 4h, to decompose the PMMA microspheres.

The green body in the muffle furnace was heated to a pre-sintering temperature of 1200 °C from the pore-forming agent decomposition temperature and thermal-insulating sintered for 2 h to form a ceramic intermediate.

The muffle furnace was switched to a vacuum sintering furnace, and the ceramic intermediate was heated to a sintering temperature of 1600 °C and thermal-insulating sintered for 3 h to form a composite fluorescent ceramic sintered element.

The composite fluorescent ceramic sintered element was annealed in an air atmosphere to form a composite fluorescent ceramic.

### Embodiment 2

In Embodiment 2, the matrix phase raw material powder includes a first nano aluminum oxide powder, and the luminescent phase raw material powder includes a second nano aluminum oxide powder, a nano yttrium oxide powder, and a nano cerium oxide powder. A YAG: Ce luminescent phase was obtained through a solid phase reaction, pores were formed through PS microspheres, and thus a composite fluorescent ceramic having a porous structure was obtained. The preparation process is as below.

Preparation of mixed powder includes: the first nano aluminum oxide powder, the second nano aluminum oxide powder, the nano yttrium oxide powder, the nano cerium oxide powder and the PS microspheres were ball-milling mixed to form mixed powder.

The mass ratio of the first nano aluminum oxide powder to the second nano aluminum oxide powder to the nano yttrium oxide powder is 2: 1, the mass of the nano cerium oxide powder is 0.4% of the mass of the nano yttrium oxide powder, and the mass of the PS microspheres is 10% of the sum of the mass of the matrix phase raw material powder and the luminescent phase raw material powder. The second nano aluminum oxide powder, the nano yttrium oxide powder and the nano cerium oxide powder were respectively weighed according to a stoichiometric ratio.

Preparation of green body includes: placing the mixed powder into a mold, and dry-pressing the mixed powder to form a green body.

The green body was placed in a muffle furnace, heated to a pore-forming agent decomposition temperature of 600 °C from room temperature, and heat-treated for 4h to decompose the PS microspheres.

The green body in the muffle furnace was heated from the pore-forming agent decomposition temperature to a pre-sintering temperature of 1300 °C and thermal-insulating sintered for 1 h, to form a ceramic intermediate.

The shape and size of ceramic intermediate was processed.

The processed ceramic intermediate was placed into a graphite mold and thermal-insulating sintered at a sintering temperature of 1500 °C for 30min using an SPS sintering furnace, to form a composite fluorescent ceramic sintered element.

The composite fluorescent ceramic sintered element was annealed in an air atmosphere to form a composite fluorescent ceramic.

### Embodiment 3

In Embodiment 3, the matrix phase raw material powder includes a first nano aluminum oxide powder, and the luminescent phase raw material powder includes a second nano aluminum oxide powder, a nano yttrium oxide powder, and a nano cerium oxide powder. A YAG: Ce luminescent phase was obtained through a solid phase reaction, and pores were formed through starch, thereby obtaining a composite fluorescent ceramic having a porous structure. The starch includes the first starch, and the preparation process thereof is as below.

Preparation of mixed slurry includes: mixing the first nano aluminum oxide powder, the nano yttrium oxide powder, the nano cerium oxide powder and the binder via first ball milling to form mixed slurry.

The mass ratio of the first nano aluminum oxide powder to the second nano aluminum oxide powder to the nano yttrium oxide powder was 1:1, the mass of the nano cerium oxide powder was 0.4% of the mass of the nano yttrium oxide powder, and the mass of the first starch was 12% of the sum of the mass of the matrix phase raw material powder and the luminescent phase raw material powder, the second nano aluminum oxide powder. The nano yttrium oxide powder and the nano cerium oxide powder were respectively weighed according to a stoichiometric ratio.

Preparation of prefabricated powder includes: processing the mixed slurry with spray granulation to form a prefabricated powder.

Preparation of YAG: Ce precursor includes: thermal-insulating sintering the prefabricated powder at a precursor sintering temperature of 1300 °C for 3 h to form YAG: Ce precursor.

YAG: Ce precursor was mixed via the third ball milling, and the ball-milled YAG: Ce precursor with third ball milling was sieved to obtain YAG: Ce precursor with preset size.

Preparation of mixed powder includes: mixing the sieved YAG: Ce precursor, the second nano aluminum oxide powder and the first starch via second ball milling to form mixed powder.

The mixed powder was dried, and the dried mixed powder was sieved.

Preparation of green body includes: dry-pressing the sieved mixed powder in a mold to form a green body.

The green body was placed in a muffle furnace, heated to a pore-forming agent decomposition temperature of 650 °C from room temperature, and heat-treated for 4h to decompose the starch.

The green body in the muffle furnace was heated to a pre-sintering temperature of 1400 °C from the pore-forming agent decomposition temperature and thermal-insulating sintered for 2 h to form a ceramic intermediate.

The muffle furnace was switched to a vacuum sintering furnace, and the ceramic intermediate was heated to a sintering temperature of 1600 °C and thermal-insulating sintered for 4 h to form a composite fluorescent ceramic sintered element.

The composite fluorescent ceramic was annealed in an air atmosphere to form a composite fluorescent ceramic.

### Embodiment 4

In Embodiment 4, the matrix phase raw material powder includes a first nano aluminum oxide powder, and the luminescent phase raw material powder includes a second nano aluminum oxide powder, a nano yttrium oxide powder, and a nano cerium oxide powder. A YAG: Ce luminescent phase was obtained through a solid phase reaction, and pores were formed through starch, thereby obtaining a composite fluorescent ceramic having a porous structure. The starch includes the first starch and the second starch, and the preparation process thereof is as below.

Preparation of mixed slurry includes: mixing the second nano aluminum oxide powder, the nano yttrium oxide powder, the nano cerium oxide powder, the binder and the second starch via first ball milling to form mixed slurry.

The mass ratio of the first nano aluminum oxide powder to the second nano aluminum oxide powder to the nano yttrium oxide powder was 5: 1, the mass of the nano cerium oxide powder was 0.4% of the mass of the nano yttrium oxide powder, the sum of the mass of the first starch and the second starch was 20% of the sum of the mass of the matrix phase raw material powder and the luminescent phase raw material powder, and the mass ratio of the first starch to the second starch was 1.25. The second nano aluminum oxide powder, the nano yttrium oxide powder and the nano cerium oxide powder were respectively weighed according to a stoichiometric ratio.

Preparation of prefabricated powder includes: processing the mixed slurry with spray granulation to form a prefabricated powder.

Preparation of YAG: Ce precursor includes: thermal-insulating sintering the prefabricated powder at a precursor sintering temperature of 1300 °C for 3 h to form YAG: Ce precursor.

YAG: Ce precursor was ball milled via third ball milling, and the ball-milled YAG: Ce precursor with the third ball milling was sieved to obtain YAG: Ce precursor with preset size.

Preparation of mixed powder includes: mixing the sieved YAG: Ce precursor, the second nano aluminum oxide powder and the first starch via second ball milling to form mixed powder.

The mixed powder was dried, and the dried mixed powder was sieved.

Preparation of green body includes: dry-pressing the sieved mixed powder in a mold to form a green body.

The green body was placed in a muffle furnace, heated to a pore-forming agent decomposition temperature of 650 °C from room temperature, and heat-treated for 4h to decompose the starch.

The green body in the muffle furnace was heated to a pre-sintering temperature of 1400 °C from the pore-forming agent decomposition temperature and thermal-insulating sintered for 2 h to form a ceramic intermediate.

The muffle furnace was switched to a vacuum sintering furnace, and the ceramic intermediate was heated to a sintering temperature of 1600 °C and thermal-insulating sintered for 4 h to form a composite fluorescent ceramic sintered element.

The composite fluorescent ceramic was annealed in an air atmosphere to form a composite fluorescent ceramic.

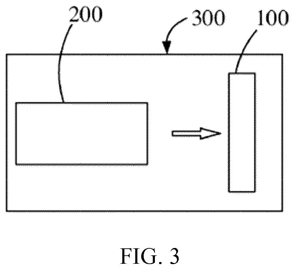

Referring to FIG. 3, FIG. 3 is a schematic structural diagram of a light emitting device of the present disclosure.

As shown in FIG. 3, the light emitting device 300 includes an excitation light source 200 and a composite fluorescent ceramic 100 according to the aforementioned embodiments. The laser light source 200 is configured to output excitation light to the composite fluorescent ceramic 100 to excite the composite fluorescent ceramic 100 to generate fluorescence. The light emitting device 300 may include a projection device or an illumination device. The excitation light source 200 may include a solid state light source, such as an LED and/or a laser.

The description is merely an implementation of the present disclosure, and is not intended to limit the patent scope of the present disclosure, and any equivalent structure or equivalent process transformation made by using the specification and accompanying drawings of the present disclosure, or other directly or indirectly applications related technical fields, which are included in the patent protection scope of the present disclosure.

## Claims

1. A composite fluorescent ceramic, comprising:
a luminescent phase comprising a plurality of luminescent crystal grains bonded together;
a matrix phase comprising a plurality of matrix crystal grains bonded together, the matrix phase and the luminescent phase being interspersed with each other and distributed in the composite fluorescent ceramic; and
pores, at least part of the pores being distributed in the luminescent phase, at least part of the pores being distributed in the matrix phase, and at least part of the pores being distributed between the luminescent phase and the matrix phase.

2. The composite fluorescent ceramic according to claim 1, wherein a volume ratio of a total volume of the pores in the composite fluorescent ceramic is less than 5% and greater than 0.1%, and/or a volume ratio of a total volume of the luminescent phase in the composite fluorescent ceramic is within a range from 10% to 90%.

3. The composite fluorescent ceramic according to claim 1 or 2, wherein a particle size of the luminescent crystal grains accounting for 60% to 95% in a total number of the composite fluorescent ceramic is 1 µm to 10 µm, and/or a particle size of the matrix crystal grains accounting for 60% to 95% in the composite fluorescent ceramic is 1 µm to 10 µm.

4. The composite fluorescent ceramic according to claim 1 or 2, wherein the luminescent phase is distributed as dispersed granules in the composite fluorescent ceramic, and the matrix phase is distributed between the dispersed luminescent phase; or
wherein the luminescent phase is distributed continuously in meshes in the composite fluorescent ceramic, and the matrix phase is distributed in meshes enclosed by the luminescent phase continuously distributed in the network; or
wherein the luminescent phase is distributed in a mixed state of both as dispersed granules and continuously in meshes in the composite fluorescent ceramic.

5. The composite fluorescent ceramic according to claim 1 or 2, wherein the luminescent phase is a lanthanide-doped garnet luminescent phase; and the matrix phase is an aluminum oxide matrix phase.

6. A method for preparing a composite fluorescent ceramic, configured to prepare the composite fluorescent ceramic according to any one of claims 1 to 5, comprising:
mixing ceramic raw materials to form mixed powder, wherein the ceramic raw materials comprise matrix phase raw material powder, luminescent phase raw material powder and pore-forming agent;
forming a green body by the mixed powder;
heat-treating the green body to remove the pore-forming agent; and
sintering the heat-treated green body to form the composite fluorescent ceramic.

7. The preparation method according to claim 6, wherein a mass of the pore-forming agent accounts for 4% to 20% of a sum of a mass of the matrix phase raw material powder and a mass of the luminescent phase raw material powder.

8. The preparation method according to claim 6 or 7, wherein the matrix phase raw material powder comprises a first aluminum oxide powder, the luminescent phase raw material powder comprises a second aluminum oxide powder, a yttrium oxide powder and a lanthanide oxide powder, a mass ratio of a sum of the first aluminum oxide powder and the second aluminum oxide powder to the yttrium oxide powder is within a range from 1:1 to 6:1, and a mass of the lanthanide oxide powder accounts for 0.1% to 2% of a mass of the yttrium oxide powder.

9. The preparation method according to claim 6, wherein said heat-treating the green body to remove the pore-forming agent comprises:
heat-treating the green body at a pore-forming agent decomposition temperature of 400 °C to 1000 °C for 0.5 h to 6 h to decompose the pore former.

10. The preparation method according to claim 9, prior to said sintering the heat-treated green body to form the composite fluorescent ceramic, comprising:
increasing the pore-forming agent decomposition temperature to a pre-sintering temperature of 1000 °C to 1600 °C, and pre-sintering the green body at the pre-sintering temperature for 0.5 h to 4 h to form a ceramic intermediate.

11. The preparation method according to claim 10, wherein said sintering the heat-treated green body to form the composite fluorescent ceramic comprises:
sintering the ceramic intermediate at a sintering temperature of 1400 °C to 1700 °C for 0.1 h to 6 h to form a composite fluorescent ceramic sintered element; and
annealing the composite fluorescent ceramic sintered element in an air atmosphere to form the composite fluorescent ceramic.

12. The preparation method according to claim 6 or 7, wherein said mixing the ceramic raw materials comprises:
mixing the luminescent phase raw material powder to prepare a prefabricated powder;
sintering the prefabricated powder at a precursor sintering temperature of 1000 °C to 1600 °C for 0.5 h to 4 h to form a luminescent phase precursor; and
mixing the luminescent phase precursor, the matrix phase raw material powder and the pore-forming agent to form the mixed powder.

13. The preparation method according to claim 6 or 7, wherein the pore-forming agent comprises a first pore-forming agent and a second pore-forming agent, and said mixing the ceramic raw materials comprises:
mixing the luminescent phase raw material powder and the first pore-forming agent to prepare a prefabricated powder;
sintering the prefabricated powder at a precursor sintering temperature of 1000 °C to 1600 °C for 0.5 h to 4 h to form a luminescent phase precursor; and
mixing the luminescent phase precursor, the matrix phase raw material powder, and the second pore-forming agent to form the mixed powder.

14. The preparation method according to claim 6 or 7, wherein the pore-forming agent is one or more of polymethyl methacrylate (PMMA) microspheres, polystyrene (PS) microspheres or starch.

15. A light emitting device, comprising an excitation light source and the composite fluorescent ceramic according to any one of claims 1 to 5.
